# EUROPEAN PATENT SPECIFICATION

(11) **EP 4 583 042 B1**
(45) Date of publication and mention of the grant of the patent: **26.08.2026**
(21) Application number: 25150159.9
(22) Date of filing: 03.01.2025
(51) Int. Cl.: G06T 5/60, G06T 5/70, G03F 7/00, G06F 30/398, G06F 30/27

(54) **METHOD AND DEVICE WITH SEMICONDUCTOR PATTERN GENERATION**
VERFAHREN UND VORRICHTUNG MIT HALBLEITERMUSTERERZEUGUNG
PROCÉDÉ ET DISPOSITIF DE GÉNÉRATION DE MOTIF DE SEMI-CONDUCTEUR

(30) Priority: 04.01.2024 KR 20240001773
(43) Date of publication of application: 09.07.2025
(73) Proprietor: Samsung Electronics Co., Ltd., Suwon-si, Gyeonggi-do 16677 (KR)
(72) Inventor: PARK, Seong-Jin, 16678 Suwon-si (KR); JEONG, Haedong, 16678 Suwon-si (KR)
(74) Representative: Arnold & Siedsma

(56) References cited:
- EP-A1- 3 958 210
- CN-A- 111 583 141
- US-B2- 11 403 737

## Description

### FIELD

The present disclosure generally relates to a processor-implemented method and a computing device. The present disclosure particularly relates to a method and device for semiconductor pattern generation.

### BACKGROUND

Patterns of a semiconductor chip may be formed by a photolithography process and an etching process. A pattern layout of circuit patterns for a semiconductor chip may be designed and the corresponding circuit patterns may be transferred from a mask onto the wafer through a photolithography process. Through this process, gaps or differences may occur between a circuit pattern transferred onto the wafer and the original designed circuit pattern. For example, such gaps or differences may occur due to an optical proximity effect in the photolithography process and/or a loading effect in the etching process. Attempts to more accurately transfer the circuit pattern on the mask onto the wafer have been made using technologies such as Process Proximity Correction (PPC) and Optical Proximity Correction (OPC) that may take into consideration a deformation of the transferred circuit pattern on the wafer.

EP3958210A1 discloses a semiconductor inspection method by an observation system including a step of acquiring a first pattern image showing a pattern of a semiconductor device, a step of acquiring a second pattern image showing a pattern of the semiconductor device and having a different resolution from a resolution of the first pattern image, a step of learning a reconstruction process of the second pattern image using the first pattern image as training data by machine learning, and reconstructing the second pattern image into a reconstructed image having a different resolution from a resolution of the second pattern image by the reconstruction process based on a result of the learning, and a step of performing alignment based on a region calculated to have a high degree of certainty by the reconstruction process in the reconstructed image and the first pattern image.

US11403737B2 discloses a method of removing noise from a depth image including presenting real-world depth images in real-time to a first generative adversarial neural network (GAN), the first GAN being trained by synthetic images generated from computer assisted design (CAD) information of at least one object to be recognized in the real-world depth image. The first GAN subtracts the background in the real-world depth image and segments the foreground in the real-world depth image to produce a cleaned real-world depth image. Using the cleaned image, an object of interest in the real-world depth image can be identified via the first GAN trained with synthetic images and the cleaned real-world depth image. The cleaned real-world depth image from the first GAN can be provided to a second GAN that provides additional noise cancellation and recovery of features removed by the first GAN.

CN111583141A discloses a virtual reality image enhancement method. The method comprises the steps of acquiring a first image used for display in virtual reality equipment; inputting the first image into a GAN network enhancement model to generate a second image corresponding to the first image through the GAN network enhancement model; inputting the first image into a restoration model to generate a third image corresponding to the first image through the restoration model; detecting semantic similarity between the second image and the third image through an image semantic recognition model to generate similarity data corresponding to the second image; and inputting the similarity data and the third image into a GAN network enhancement model to generate a corresponding fourth image through the GAN network enhancement model. The image obtained from the virtual reality equipment can be enhanced and restored through the GAN network enhancement model, so that the quality of the image displayed by the virtual reality equipment is greatly improved.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

Aspects of the present disclosure are defined in the appended independent claims. Preferred embodiments are provided in the appended dependent claims.

Other features and aspects will be apparent from the following detailed description, the drawings, and the claims.

### BRIEF DESCRIPTION OF THE DRAWINGS

FIG. 1 illustrates an example semiconductor pattern generation process of a computing device according to one or more embodiments.
FIG. 2 illustrates an example method with semiconductor pattern generation according to one or more embodiments.
FIG. 3 is a flowchart of an example method with a semiconductor pattern generation according to one or more embodiments.
FIG. 4 is a flowchart of an example method with a semiconductor pattern generation according to one or more embodiments.
FIGS. 5 to 8 illustrate example implementation results of semiconductor pattern generation according to one or more embodiments.
FIG. 9 illustrates an example electronic device according to one or more embodiments.

Throughout the drawings and the detailed description, unless otherwise described or provided, the same drawing reference numerals may be understood to refer to the same or like elements, features, and structures. The drawings may not be drawn to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order (e.g., a certain order). Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment (e.g., as to what an example or embodiment may include or implement) means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment", and "one or more examples" has a same meaning as "in one or more embodiments").

Throughout the specification, when a component or element is described as being "on", "connected to," "coupled to," or "joined to" another component, element, or layer it may be directly (e.g., in contact with the other component, element, or layer) "on", "connected to," "coupled to," or "joined to" the other component, element, or layer or there may reasonably be one or more other components, elements, layers intervening therebetween. When a component, element, or layer is described as being "directly on", "directly connected to," "directly coupled to," or "directly joined" to another component, element, or layer there can be no other components, elements, or layers intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Unless otherwise defined, all terms, including technical and scientific terms, used herein have the same meaning as commonly understood by one of ordinary skill in the art to which this disclosure pertains and specifically in the context on an understanding of the disclosure of the present application. Terms, such as those defined in commonly used dictionaries, are to be interpreted as having a meaning that is consistent with their meaning in the context of the relevant art and specifically in the context of the disclosure of the present application, and are not to be interpreted in an idealized or overly formal sense unless expressly so defined herein.

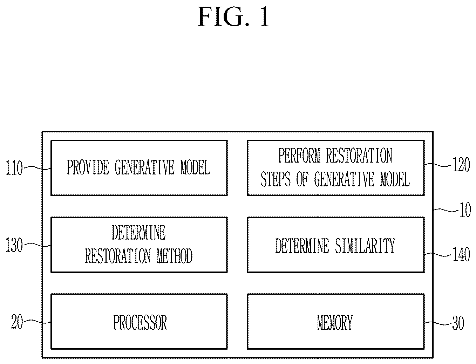

FIG. 1 illustrates an example semiconductor pattern generation process of a computing device according to one or more embodiments.

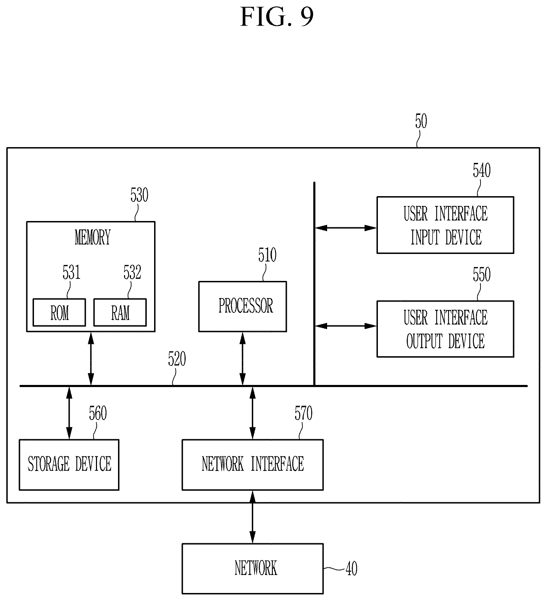

Referring to FIG. 1, a computing device 10 may comprise one or more memories 30 and one or more processors 20. As a non-limiting example, the computing device 10 may be the electronic device 50 as described below with reference to FIG. 9. For example, the one or more processors 20 may correspond to the one or more processors 510 of the electronic device 50, and the one or more memories 30 may correspond to the one or more memories 530 of the electronic device 50.

The computing device 10 may be configured to perform a model providing operation **110** (e.g., to the one or more processors 20) of providing a generative model, reverse process operations 120 (e.g., by any one or any combination of the one or more processors 20) of performing restoration steps of the generative model, similarity determining operations 140 (e.g., by any one or any combination of the one or more processors 20) of determining respective similarities between step results of different performances of the reverse process operations 120, and restoration method determining operations 130 (e.g., by any one or any combination of the one or more processors 20) of determining respective restoration methods for the reverse process operations 120 based on corresponding results of the similarity determining operations 140.

The model providing operation 110 may prepare the generative model (e.g., a diffusion model) trained with a semiconductor pattern image. The generative model may be stored in any one of the one or more memories 30 and/or may be loaded from the any of the one or more memories 30 into another any of the one or more memories 30 to be provided to any of the one or more processors 20 for implementing the generative model to generate the semiconductor pattern. While examples are not limited to the same, for explanatory purposes, examples below will be provided based on the generative model being the diffusion model. Accordingly, any or any combination of the one or more processors 20 may be configured to perform any one or any combination of operations described herein, including any or all of the model providing operation 110, reverse process operations 120, restoration method determining operations 130, and similarity determining operations 140, as non-limiting examples. For example, the one or more processors 20 may be configured to execute instructions that may be stored in any of the one or more memories 30, such that execution of the instructions by the one or more processors 20 configure the one or more processors 20 to perform any or any combination of the operations described herein, including any or all of the model providing operation 110, reverse process operations 120, restoration method determining operations 130, and similarity determining operations 140, as non-limiting examples.

A diffusion model or a diffusion probabilistic model is a type of generative model, and may model a process of generating data as a diffusion process. Specifically, a diffusion model may be trained to have generative and restorative properties by first performing a forward process through a noise adding diffusion model that incrementally transforms input data (e.g., an input image) to generated complete noise, as only an example, by repeating a stepped process of gradually (e.g., from 0-th through T-th steps) adding noise to the data. The diffusion model having generative and restorative properties may be trained through a reverse stepped process that regenerates the data by repeating a stepped process of gradually (e.g., from T'-th through 0-th steps) restoring or denoising the complete noise. In a typical simplest approach, T' may equal T, so there may be same number of restorative (or denoising) steps in the diffusion model with generative and restorative properties as the number of noise adding steps in the noise adding diffusion model. For example, the noise adding diffusion model may add noise to an input image I₀ and incrementally add noise for each time step t until the final image I_{T} is generated, and the diffusion model with generative and restorative properties may input image I_{T} and incrementally restore (or denoise) for each time step t until a final image I_{F} is generated. Likewise, in the typical simplest approach, the diffusion model with generative and restorative properties may be trained so image I_{F} is the same as image I₀, or image I_{F} may be slightly or substantially different from image I₀ based upon conditional or other information that is also considered by the diffusion model with generative and restorative properties. As a non-limiting example, each step of the noise adding diffusion model may include a set of AI or other machine-learning components, such as plural neural network layers as non-limiting examples, configured to each add noise to data input to that set of AI or other machine learning components, such that with each set of the AI or other machine-learning components follows a previous set of the AI or other machine-learning components, that respectively perform the incremental noise adding. As a non-limiting example, each step of the diffusion model with generative or restorative properties may include another set of AI or other machine-learning components, such as plural neural network layers as non-limiting examples, configured to each remove noise from data input to that set of other AI or other machine learning components, such that with each set of the other AI or other machine-learning components follows a previous set of the other AI or other machine-learning components, that respectively perform the incremental restoration or noise removing. Hereinafter, for ease of explanation, the noise adding diffusion model may be referred to as a forward process, forward, diffusion process, forward diffusion model, etc., and the diffusion model with generative and restorative properties may be referred to as a reverse process, a reverse diffusion process, a generative reverse diffusion process, generative reverse diffusion model, etc.

The model providing operation 110 may prepare and provide the generative reverse diffusion model trained with the reverse process of restoring original semiconductor pattern image data from an input semiconductor pattern image data to which noise has been added. In an example, the generative reverse diffusion model may be trained to generate new data corresponding to the original semiconductor pattern image from data to which noise is added as a semiconductor pattern image including microstructures of a semiconductor chip, for example, various hardware component parts such as a gate pattern that constitutes a transistor, an interconnect that connects elements inside the semiconductor chip to each other and provides a path of current, a contact hole used to connect an upper layer and a lower layer, a memory cell pattern with a data storage function, a power rail that distributes power to the semiconductor chip, etc.

The reverse process operation 120 may set a total of n steps (where n is an integer greater than 1) to perform the reverse process of the generative reverse diffusion model, and the restoration method determining operation 130 may set the current restoration method to a first restoration method, which may also be referred to herein as a first set restoration process. Here, the first restoration method may include a method of restoring a next step image by performing denoising (removing noise) on the current step image and then adding random noise. Subsequently, the reverse process operation 120 may restore an (n-1)-th step image from an n-th step image that starts the reverse process based on the first restoration method set by the restoration method determining operation 130. Here, the value of n may be set to a determined appropriate value according to a purpose of implementation, an implementation environment, etc. That is, the reverse process operation 120 may remove one step of noise from the n-th step image that starts the reverse process, then add random noise before completing a restoration step, and restore the image to which the random noise has been added as the (n-1)-th step image.

The reverse process operation 120 may then repeat restoration based on the first restoration method until a k-th step image (where k is an integer of n-1 or less) is eventually obtained from the (n-1)-th step image. Here, the value of k may be set to a determined appropriate value according to a purpose of implementation, an implementation environment, etc., and, in particular, performance and efficiency may be considered in terms of generating a semiconductor pattern through the generative reverse diffusion model.

The similarity determining operation 140 may obtain a first feature by performing feature extraction on the k-th step image. In some embodiments, the first feature may include at least one of color, texture, shape, boundary, detailed pattern, and feature point. In some other embodiments, the first feature may include a semantic feature. Here, the semantic feature may be a feature that represents the meaning or content of an object expressed by an image.

The reverse process operation 120 may then repeat restoration until a (k-j)-th step image (where j is an integer greater than 0) is eventually obtained from the k-th step image based on the first restoration method. Here, the value of j may be set to a determined appropriate value according to a purpose of implementation, an implementation environment, etc., and, in particular, performance and efficiency may be considered in terms of generating a semiconductor pattern through the generative reverse diffusion model.

The similarity determining operation 140 may obtain a second feature by performing feature extraction on the (k-j)-th step image. In some embodiments, the second feature, like the first feature, may include at least one of color, texture, shape, boundary, detailed pattern, and feature point. In some other embodiments, the second feature, like the first feature, may include the semantic feature.

In some embodiments, feature extraction may be accomplished by using a separate feature extraction model, or may be accomplished by utilizing internal features used in the generative reverse diffusion model.

The similarity determining operation 140 may then determine a similarity between the k-th step image and the (k-j)-th step image based on the first feature and the second feature. In some embodiments, the similarity determining operation 140 may measure the similarity by converting the first feature into a first feature vector and converting the second feature into a second feature vector, and comparing the first feature vector with the second feature vector. Also, the similarity determining operation 140 may assign a similarity score to a measurement result, and, when the similarity score meets a predetermined threshold (e.g., is the predetermined threshold or more), determine that the k-th step image and the (k-j)-th step image are similar.

In some embodiments, measuring the similarity by comparing the first feature vector with the second feature vector may include measuring the similarity between the first feature vector and the second feature vector through at least one of Euclidean Distance, Cosine Similarity, and Manhattan Distance-based methods. Euclidean distance-based similarity measurement may be a method of measuring a straight-line distance between the first feature vector and the second feature vector, and cosine similarity-based similarity measurement may be a method of measuring an angle between the first feature vector and the second feature vector and focusing on directionality. Manhattan distance-based similarity measurement may be a method of measuring a distance (i.e., Manhattan distance) between the first feature vector and the second feature vector measured along a grid-shaped path.

When the similarity determining operation 140 determines that the similarity is higher than a predetermined level, the restoration method determining operation 130 may set the current restoration method as a second restoration method, which may also be referred to herein as a second set restoration process, that is different from the first restoration method. Here, the second restoration method may include a method of restoring a next step image by only performing denoising on a current step image. That is, the second restoration method may be a method of restoring the current step image from which noise has been removed by one step as the next step image without adding random noise. The reverse process operation 120 may then repeat restoration until a 0-th step image, as a non-limiting example, is eventually restored from the (k-j)-th step image based on the second restoration method. Here, as such a non-limiting example, the 0-th step image may be a finally generated semiconductor pattern image output by the generative reverse diffusion model.

In particular, a time step length of the first restoration method may be different from a time step length of the second restoration method. For example, a second time step may be a subset of a first time step. Accordingly, the interval of second time steps may be set longer than the interval of first time steps. Herein, while examples have been given where the steps of each of the forward diffusion model and the generative reverse diffusion model have been explained as being time dependent, i.e., respectively correlated to steps of set units of time, such as the first set unit of time of the example first restoration method and the different second set unit of time of the example second restoration method, such examples are for explanative purposes only and such steps may not be units of time but merely respective strides or other scheduled divisions of the whole or sub-whole portions of the aforementioned total number of T or T' steps of the forward diffusion model or as originally trained generative reverse diffusion model.

Unlike when the similarity determining operation 140 determines that the similarity is higher than a predetermined level, when the similarity determining operation 140 determines that the similarity fails to meet the predetermined threshold (e.g., is less than the predetermined level), the reverse process operation 120 may repeat restoration until a (k-j-m)-th step image (where m is an integer greater than 0) is eventually obtained from the (k-j)-th step image based on the first restoration method. Here, the value of m may be set to a determined appropriate value according to a purpose of implementation, an implementation environment, etc., and, in particular, performance and efficiency may be considered in terms of generating a semiconductor pattern through the generative reverse diffusion model. Meanwhile, the similarity determining operation 140 may re-perform similarity determination on the (k-j-m)-th step image and a subsequent step image.

In some embodiments, similarity may be considered to determine the value of m. Specifically, when the similarity is determined to have failed to meet a predetermined minimum level (e.g., is determined to be less than the predetermined minimum level), the value of m may be specified as a value that is a predetermined minimum value or more. For example, if a value representing the minimum level of similarity is S_{M} and the minimum value is i_{M}, when the similarity between the k-th step image and the (k-j)-th step image determined by the similarity determining operation 140 does not reach S_{M} that is the minimum level of similarity, the value of m may be set to a sufficiently large value (i.e., a value at least equal to or greater than the minimum value i_{M}). Accordingly, because the similarity between the k-th step image and the (k-j)-th step image is not high, when the similarity determination is re-performed in a subsequent step, the number of re-performing may be controlled not to unnecessarily increase.

In an example, in the inference of the generative reverse diffusion model trained with a semiconductor pattern image, from a start step of a reverse process until changes in images corresponding to an intermediate step of restoration decrease below a predetermined standard, the first restoration method of adding random noise for each time step is adopted such that a sufficient diversity of generation results is secured, and when a step in which the changes in the images corresponding to the intermediate step of restoration decrease below the predetermined standard (for example, a step of determining that the overall form of an image has been completed to some extent, or a step of determining that the semantic feature of the image has been established to some extent) is reached, the second restoration method of increasing the interval of time steps and no longer adding random noise is adopted, and thus, an inference speed may be increased and computing resources may be saved. In particular, if only the first restoration method is applied for all time steps, the noise added for each time step may not be sufficiently removed once the last restoration step is complete to provide a final generation result and may remain in the final generation result, which may cause a problem in which the remaining noise may not be elaborate when generating contours. If only the second restoration method is applied for all time steps, a problem may occur in which a diversity of the final generation result may not be secured. Rather, various embodiments at least the first restoration method and the second restoration method, as non-limiting example, may be utilized, thereby reducing or minimizing any noise that may remain in the final generation result, and/or with diversity being accomplished, thereby not only generating an elaborate semiconductor pattern but also improving the performance efficiency compared to previous approaches.

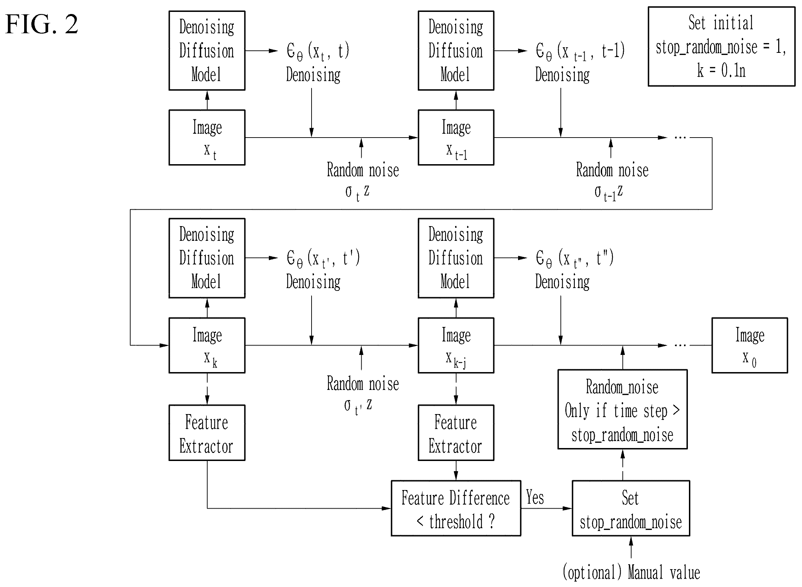

FIG. 2 illustrates an example method with semiconductor pattern generation according to one or more embodiments.

Referring to FIG. 2, an image xₜ₋₁ may be restored from an image xₜ in a reverse process of a generative reverse diffusion model (or a denoising diffusion model) based on a first restoration method. Specifically, the generative reverse diffusion model performs denoising on the image xₜ as expressed in ε_{θ}(xₜ, t), and random noise is added to the image xₜ as expressed in σₜ z so that the image xₜ₋₁ may be restored. Subsequently, image restoration in a subsequent step from the image xₜ₋₁ may be repeated, and then eventually after further steps an image xₖ may be restored.

After the image xₖ is restored, feature extraction may be performed on the image xₖ. Subsequently, image restoration in subsequent steps from the image xₖ (e.g., after the denoising based on ε_{θ}(x_{t'}, t') and adding of noise σₜ^{,}z) may be repeated and then, an image xₖ₋ⱼ may eventually be restored, and after the image _{Xk-j} is restored, feature extraction may be performed on the image xₖ₋ⱼ. When features extracted with respect to the image xₖ and the image _{Xk-j} are compared and a difference in the features does not meet a predetermined threshold (e.g., when it is determined that similarity between the image xₖ and the image _{Xk-j} is a predetermined level or more), restoration may be repeated (e.g., starting with the restored image _{Xk-j} based on ε_{θ}(x_{t'}, t') ) until an image x₀ is restored from the image xₖ₋ⱼ, without adding random noise, based on a second restoration method different from the first restoration method.

In some embodiments, a variable that may store in memory the value of a time step at which the reverse process of the generative reverse diffusion model proceeds may be set. The computing device 10 may compare a value stored in memory representing a time step of the current step in the reverse process with the value stored in the variable. When the value representing the time step of the current step is greater than the value stored in the variable, a next step image may be restored by performing denoising on a current step image based on the first restoration method and then adding random noise. Unlike this, when the value representing the time step of the current step is less than or equal to the value stored in the variable, the next step image may be restored by performing only denoising on the current step image based on the second restoration method that is different from the first restoration method.

Specifically, the reverse process may proceed with time steps of a total of n steps (where n is an integer greater than 1), and the computing device 10 may restore the (n-1)-th step image from the n-th step image that starts the reverse process based on the first restoration method, and then repeat restoration until the k-th step image is eventually obtained from the (n-1)-th step image. Subsequently, the computing device 10 may perform feature extraction on the k-th step image to obtain a first feature, repeat restoration until the (k-j)-th step image is eventually obtained from the k-th step image based on the first restoration method, perform feature extraction on the (k-j)-th step image to obtain a second feature, and then determine the similarity between the k-th step image and the (k-j)-th step image based on the first feature and the second feature.

When it is determined that the similarity meets a predetermined level (e.g., is the predetermined level or more), the computing device 10 may set the value of the variable to k-j. Accordingly, when the value representing the time step of the current step is less than or equal to k-j stored in the variable, the first restoration method may be switched to the second restoration method.

When it is determined that the similarity fails to meet the predetermined level (for example, is less than the predetermined level), the computing device 10 may repeat restoration until the (k-j-m)-th step image (where m is an integer greater than 0) is eventually obtained from the (k-j)-th step image based on the first restoration method, and re-perform similarity determination on the (k-j-m)-th step image and a subsequent step image.

For example, the variable that may store in memory the value of the time step at which the reverse process of the generative reverse diffusion model proceeds may have the name "stop_random_noise". 1 may be set in "stop_random_noise" as an initial value. As a result of performing feature extraction on the k-th step image to obtain the first feature, repeating restoration until the (k-j)-th step image is eventually obtained from the k-th step image based on the first restoration method, performing feature extraction on the (k-j)-th step image to obtain the second feature, and then determining the similarity between the k-th step image and the (k-j)-th step image based on the first feature and the second feature. When it is determined that the similarity meets a predetermined level (e.g., is the predetermined level or more), the computing device 10 may set the value of the variable "stop_random_noise" to k-j. Then, when the value representing the time step of the current step is less than or equal to k-j stored in the variable, the first restoration method may be switched to the second restoration method.

In some embodiments, the value of the variable may be set to a predetermined value indicating a ratio of time steps performed based on the first restoration method and the second restoration method. In this case, when similarity between images is not determined, and the value representing the time step of the current step is less than or equal to a value set as a predetermined value stored in the variable, the first restoration method may be switched to the second restoration method. For example, when "Manual value" is set in the variable "stop_random_noise", similarity between images is not determined, and the value representing the time step of the current step is less than or equal to "Manual value" stored in the variable, the first restoration method may be switched to the second restoration method.

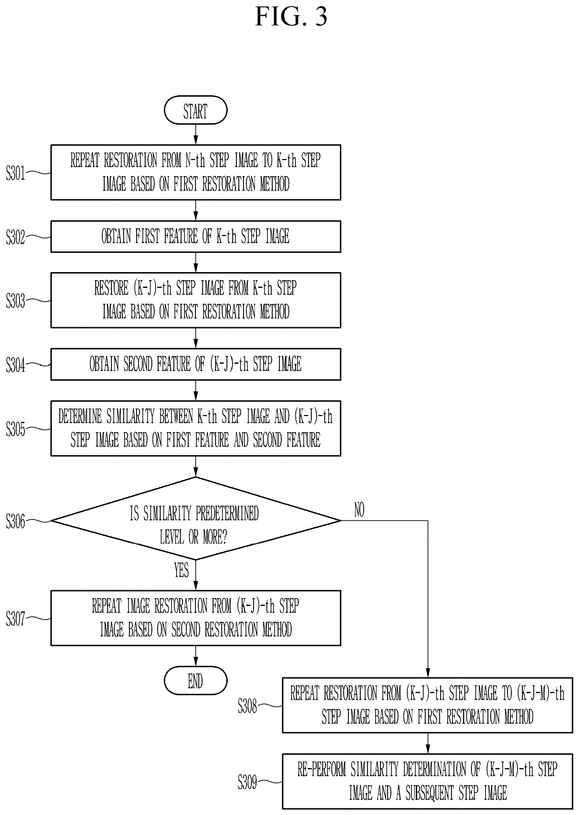

FIG. 3 is a flowchart of an example method with a semiconductor pattern generation according to one or more embodiments.

Referring to FIG. 3, the method of generating the semiconductor pattern according to an embodiment may include restoring the k-th step image from the n-th step image based on a first restoration method (performing restoration operations repeatedly from the n-th step image ) (for example, performing a first sequence of the restorative operations of the generative model) (S301), obtaining a first feature of the k-th step image (S302), restoring the (k-j)-th step image from the k-th step image based on the first restoration method (for example, performing a second sequence of the restorative operations of the generative model) (S303), obtaining a second feature of the (k-j)-th step image (S304), determining similarity between the k-th step image and the (k-j)-th step image based on the first feature and the second feature (S305), and determining whether the similarity is a predetermined level or more (S306).

When it is determined that the similarity is the predetermined level or more, the method of generating the semiconductor pattern may perform repeating image restoration from the (k-j)-th step image based on a second restoration method (for example, performing a third sequence of the restorative operations of the generative model) (S307).

Unlike this, when it is determined that the similarity is not the predetermined level or more (for example, less than the predetermined level), the method of generating the semiconductor pattern may include restoring the (k-j-m)-th step image from the (k-j)-th step image based on the first restoration method (performing restoration operations repeatedly from the (k-j)-th step image) (S308), and re-performing similarity determination of the (k-j-m)-th step image and a subsequent step image (S309). For example, when the similarity determination of the (k-j-m)-th step image and the subsequent step image is determined to meet a predetermined minimum level (for example, be the predetermined level or more), the method of generating the semiconductor pattern may cease performing subsequent restorative operations based on a first restoration method and perform repeating image restoration from the subsequent step image based on a second restoration method (for example, performing the third sequence of the restorative operations of the generative model).

As non-limiting example, more specific details of the method of generating the semiconductor pattern may be referred to the descriptions above provided with reference to FIGS. 1 and 2, and thus, redundant descriptions have been omitted here.

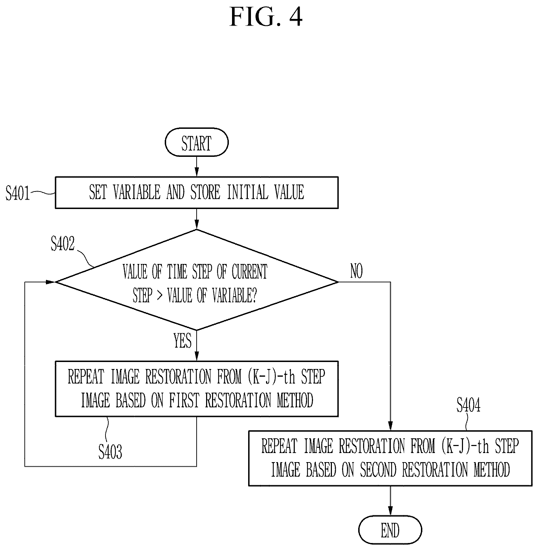

FIG. 4 is a flowchart of an example method with a semiconductor pattern generation according to one or more embodiments.

Referring to FIG. 4, the method of generating the semiconductor pattern according to an embodiment may include setting a variable capable of storing the value of a time step at which a reverse process of a generative reverse diffusion model proceeds and storing an initial value (S401) and determining whether the value of a time step of the current step is greater than the value of the variable (S402).

When it is determined that the value of the time step of the current step is greater than the value of the variable, the method of generating the semiconductor pattern may perform repeating image restoration from the (k-j)-th step image based on a first restoration method (S403).

Unlike this, when it is determined that the value of the time step of the current step is less than or equal to the value of the variable, the method of generating the semiconductor pattern may perform repeating image restoration from the (k-j)-th step image based on a second restoration method (S404).

More specific details of the method of generating the semiconductor pattern may be referred to the descriptions above provided with reference to FIGS. 1 - 3, and thus, redundant descriptions have been omitted here.

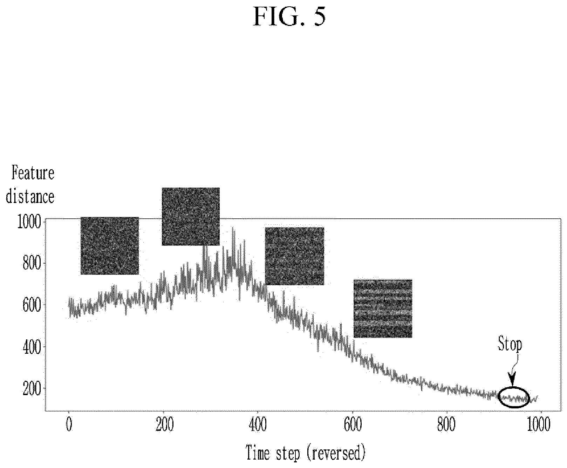

FIGS. 5 to 8 show example implementation results of semiconductor pattern generation according to one or more embodiments.

As previously explained, when only the first restoration method is implemented, the noise added for each time step may not be sufficiently removed from a final generation result and may remain in the final generation result, which may cause a problem in which the remaining noise may not be elaborate when generating contours (for example, a problem in which boundaries of straight lines may be uneven and the overall elaboration of a layout may deteriorate). Rather, when only the second restoration method is implemented, a problem may occur in which diversity of the final generation result is not secured.

FIG. 5 illustrates an example where a total of 1000 time steps were set, and where the value of the above example "stop_random_noise " was set to 5 % of the total time steps. Accordingly, after a reverse process started, restoration of the image was repeated based on the first restoration method in a period corresponding to 950 time steps, and restoration of the image was repeated based on the second restoration method in a period corresponding to the remaining 50 time steps. As non-limiting examples, a vertical axis of FIG. 5 may refer to a feature distance. For example, a smaller feature distance may indicate a greater similarity between images.

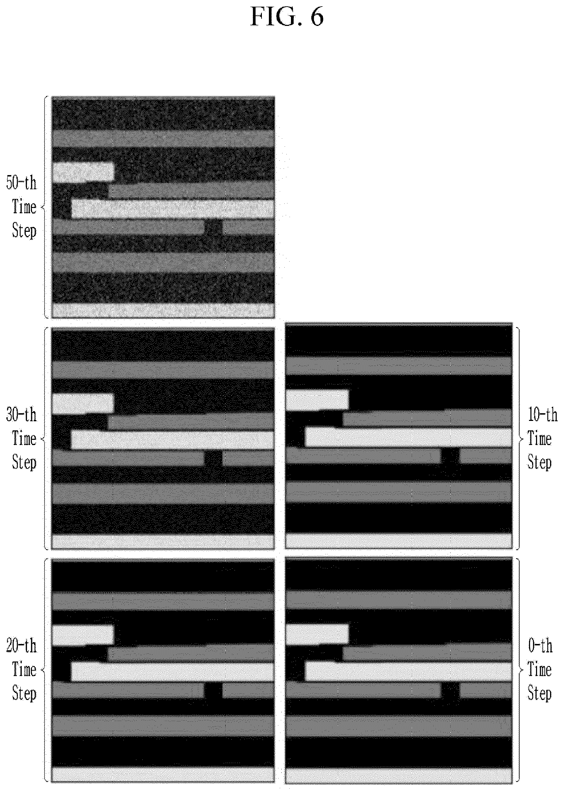

FIG. 6 illustrates example restoration results of an intermediate image, after 950 time steps among the total of 1,000 time steps have been performed according to the first restoration method, in 50-th, 30-th, 20-th, 10-th, and 0-th (final) time steps. In FIG. 6, it can be seen that it may be sufficient that only denoising was performed and random noise not added when the intermediate image is restored at each time step after cessation of the first restoration method. For example, sufficient diversity may have been secured by the first 950 time steps, so the remaining 50 time steps may focus on accelerating an inference speed rather than diversity. In particular, the length of one time step corresponding to the remaining 50 time steps was set to be longer than the length of one time step corresponding to the previous 950 time steps, which further accelerated the inference speed.

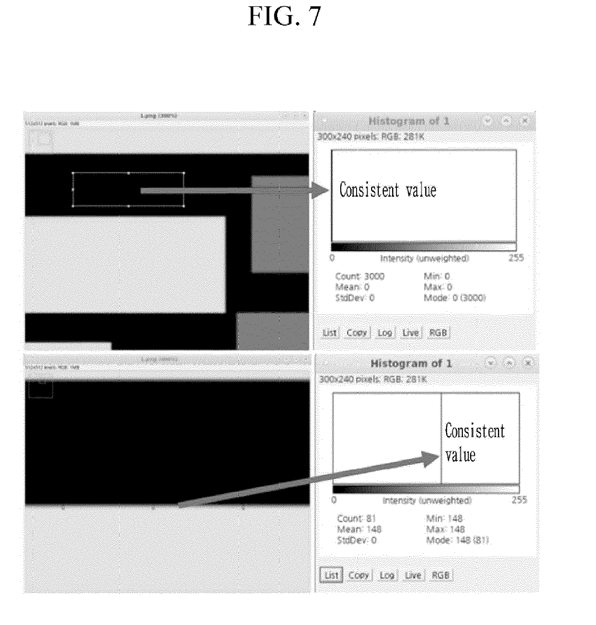

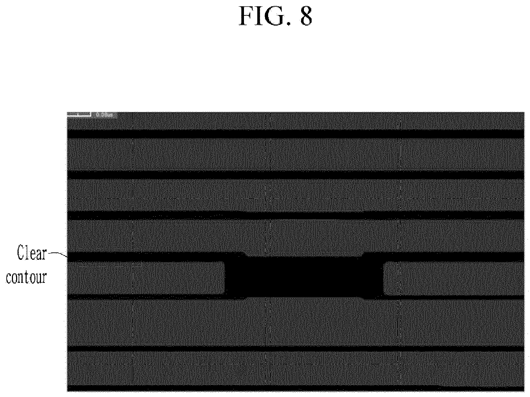

FIGS. 7 and 8 illustrate example final resultants obtained according to embodiments. As highlighted in FIG. 7, it can be seen that boundaries of straight lines were formed evenly to have a constant value. In FIG. 8, it can be seen that a layout contour was formed elaborately and clearly.

FIG. 9 illustrates an example electronic device according to one or more embodiments.

An electronic device 50 may include one or more processors 510, one or more memories 530, a user interface input device 540, a user interface output device 550, and one or more storage devices 560 that communicate over a bus 520. The electronic device 50 may also include a network interface 570 that is electrically connected to a network 40. The network interface 570 may transmit or receive signals to and from other entities over the network 40. In non-limiting examples, the electronic device 50 may be the computing device 10 of FIG. 1, or the one or more processors 510 and the one or more memories 530 may correspond to the computing device 10.

The one or more processors 510 may be or include various types of processors, such as any one or any combination of a Central Processing Unit (CPU), an Application Processor (AP), a Graphics Processing Unit (GPU), a Neural Processing Unit (NPU), a Micro Controller Unit (MCU), etc., or may be any semiconductor device that executes instructions stored in the one or more memories 530 or the one or more storage devices 560, for example. The one or more processors 510 may be configured to perform any one or any combination of operations described herein with respect to FIGS. 1-8, as non-limiting examples.

The one or more memories 530 and the one or more storage devices 560 may include various types of volatile or non-volatile storage media. For example, the one or more memories 530 may include read-only memory (ROM) 531 and random access memory (RAM) 532. In various embodiments, the one or more memories 530 may be located inside and/or outside the one or more processors 510, and the one or more memories 530 may be connected to the one or more processors 510 through various known means.

According to one or more embodiments, in an inference of a generative reverse diffusion model trained with a semiconductor pattern image, from a start step of a reverse process until changes in images corresponding to an intermediate step of restoration decrease below a predetermined standard, a first restoration method of adding random noise for each time step may be adopted such that a sufficient diversity of generation results is secured, and when a step in which the changes in the images corresponding to the intermediate step of restoration decrease below the predetermined standard (for example, a step of determining that the overall form of an image has been completed to some extent, or a step of determining that the semantic feature of the image has been established to some extent) is reached, a second restoration method of increasing the interval of time steps and stopping adding random noise may be adopted, and thus, an inference speed may be increased and computing resources may be saved.

The computing devices, electronic devices, processors, memories, user interface input devices, user interface output devices, storage devices, network interfaces, networks, and buses described herein, including descriptions with respect to FIGS. 1-9, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both, and thus while some references may be made to a singular processor or computer, such references also are intended to refer to multiple processors or computers. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in, and discussed with respect to, FIGS. 1-9 that perform the operations described in this application are performed by computing hardware, for example, by one or more processors or computers, implemented as described above implementing instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations. References to a processor, or one or more processors, as a non-limiting example, configured to perform two or more operations refers to a processor or two or more processors being configured to collectively perform all of the two or more operations, as well as a configuration with the two or more processors respectively performing any corresponding one of the two or more operations (e.g., with a respective one or more processors being configured to perform each of the two or more operations, or any respective combination of one or more processors being configured to perform any respective combination of the two or more operations).

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), a card type memory such as multimedia card or a micro card (for example, secure digital (SD) or extreme digital (XD)), magnetic tapes, floppy disks, magneto-optical data storage devices, optical data storage devices, hard disks, solid-state disks, and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope as defined by the appended claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components.

## Claims

1. A processor-implemented method, the method comprising:
generating a first image by performing (S301), based on a first set restoration process, a first sequence of restorative operations of a generative model that is initially provided an input image, wherein the generative model is a circuitry pattern-based generative model having a plurality of restorative operations;
generating a second image by performing (S303), based on the first set restoration process, a second sequence of restorative operations of the generative model continuing from the first image; and
generating, depending on a determined similarity between the first image and the second image, a final semiconductor pattern by performing (S307), based on a second set restoration process that is different from the first set restoration process, multiple restorative operations including a third sequence of restorative operations of the generative model continuing from the second image.

2. The method of claim 1, wherein the first set restoration process includes performing a corresponding restoration operation of the generative model by performing denoising on a current image and then adding random noise to a result of the denoising, and
wherein the second set restoration process includes performing a different corresponding restoration operation of the generative model by performing the denoising without the adding of the random noise to the result of the denoising.

3. The method of claim 1 or 2, further comprising performing (S305) the determining of the similarity between the first image and the second image based on a first feature extracted from the first image and a second feature extracted from the second image, and determining whether the similarity meets a predetermined level,
wherein the generating of the final semiconductor pattern comprises:
when a result of the determining of whether the similarity meets the predetermined level is that the similarity meets the predetermined level, performing (S307) the third sequence of restorative operations of the generative model continuing from the second image, such that a final restorative operation of the third sequence is a final restorative operation of the generative model that outputs the final semiconductor pattern; and
when the result of the determining of whether the similarity meets the predetermined level is that the similarity does not meet the predetermined level, generating respective third images by performing (S308) subsequent restorative operations, of the multiple restorative operations continuing from the second image, based on the first set restoration process and prior to the third sequence of restorative operations.

4. The method of claim 3, wherein the generating of the final semiconductor pattern comprises, when a performed similarity determination (S309) between one of the respective third images and a subsequent one of the respective third images is determined to meet a predetermined minimum level, ceasing the performing of the subsequent restorative operations and begin performing the third sequence of restorative operations of the generative model continuing from the subsequent one of the respective third images, such that the final restorative operation of the third sequence is the final restorative operation of the generative model that outputs the final semiconductor pattern.

5. The method according to any of the previous claims, further comprising performing the determining of the similarity between the first image and the second image by:
extracting (S302, S304) a first feature and a second feature from the first image and the second image, respectively;
converting the first feature and the second feature into a first feature vector and a second feature vector, respectively;
measuring the similarity between the first image and the second image by comparing the first feature vector with the second feature vector;
assigning a similarity score to a result of the measuring, and determining whether the similarity score meets a predetermined threshold; and
in response to the similarity score being determined to meet the predetermined threshold, determining that the first image and the second image are similar, and performing the third sequence of restorative operations of the generative model continuing from the second image, such that a final restorative operation of the third sequence is a final restorative operation of the generative model that outputs the final semiconductor pattern.

6. The method according to claim 5, wherein the measuring of the similarity between the first image and the second image includes measuring a similarity between the first feature vector and the second feature vector through at least one of Euclidean Distance, Cosine Similarity, and Manhattan Distance-based measurements.

7. The method according to any of the previous claims, wherein the plurality of restorative operations of the generative model are respectively differently timed restorative operation steps, from a first restorative operation step to intermediary restorative operation steps to a final restorative operation step that corresponds to a final restorative operation of the generative model, and
wherein a sequencing of corresponding restorative operations, of the generative model when implemented based on the first set restoration process, is according to a first time step length that is different from a second time step length of the second set restoration process that defines a sequencing of other corresponding restorative operations of the generative model when implemented based on the second set restoration process.

8. The method of claim 7, wherein the second time step length is longer than the first time step length.

9. The method of any of the previous claims, further comprising performing the determining of the similarity between the first image and the second image by respectively extracting a first feature from the first image and a second feature from the second image and comparing the first feature to the second feature,
wherein the first feature and the second feature each include at least one of color, texture, shape, boundary, detailed pattern, and feature point, and/or wherein the first feature and the second feature each include a semantic feature.

10. The method according to any of the previous claims, further comprising:
setting a first variable in a memory to store a value of a time step at which a restorative operation of the generative model based on the second set restoration process is set to proceed;
maintaining a second variable in the memory to represent decrementing integer values for current time steps of respective restorative operations of the generative model as the plurality of restorative operations are being performed; and
performing the third sequence of the generative model when the second variable reaches the first variable.

11. A non-transitory computer-readable storage medium (10; 530; 560) storing instructions which, when executed by one or more processors, cause the one or more processors to perform the method according to any of the previous claims.

12. A computing device (10; 50), comprising one or more processors (20; 510) configured to perform the method according to any of the claims 1-10.

## Patentansprüche

1. Prozessorimplementiertes Verfahren, wobei das Verfahren Folgendes umfasst:
basierend auf einem ersten eingestellten Wiederherstellungsprozess Erzeugen eines ersten Bildes durch Durchführen (S301) einer ersten Sequenz von Wiederherstellungsoperationen eines generativen Modells, dem anfänglich ein Eingabebild bereitgestellt wurde, wobei es sich bei dem generativen Modell um ein auf Schaltkreismustern basierendes generatives Modell mit einer Vielzahl von Wiederherstellungsoperationen handelt;
basierend auf dem ersten eingestellten Wiederherstellungsprozess Erzeugen eines zweiten Bildes durch Durchführen (S303) einer zweiten Sequenz von Wiederherstellungsoperationen des generativen Modells ausgehend von dem ersten Bild; und
Erzeugen eines letzten Halbleitermusters in Abhängigkeit von einer bestimmten Ähnlichkeit zwischen dem ersten Bild und dem zweiten Bild durch Durchführen (S307), basierend auf einem zweiten eingestellten Wiederherstellungsprozess, der sich von dem ersten eingestellten Wiederherstellungsprozess unterscheidet, mehrerer Wiederherstellungsoperationen einschließlich einer dritten Sequenz von Wiederherstellungsoperationen des generativen Modells ausgehend von dem zweiten Bild.

2. Verfahren nach Anspruch 1, wobei der erste eingestellte Wiederherstellungsprozess das Durchführen einer entsprechenden Wiederherstellungsoperation des generativen Modells durch Durchführen eines Entrauschens eines aktuellen Bildes und anschließendes Hinzufügen von Zufallsrauschen zum Ergebnis des Entrauschens umfasst, und
wobei der zweite eingestellte Wiederherstellungsprozess das Durchführen einer anderen entsprechenden Wiederherstellungsoperation des generativen Modells durch Durchführen eines Entrauschens ohne Hinzufügen eines Zufallsrauschens zu dem Ergebnis des Entrauschens umfasst.

3. Verfahren nach Anspruch 1 oder 2, ferner umfassend das Durchführen (S305) der Ähnlichkeitsbestimmung zwischen dem ersten Bild und dem zweiten Bild basierend auf einem ersten aus dem ersten Bild extrahierten Merkmal und einem zweiten aus dem zweiten Bild extrahierten Merkmal, und das Bestimmen, ob die Ähnlichkeit ein vorbestimmtes Niveau erreicht, wobei das Erzeugen des endgültigen Halbleitermusters Folgendes umfasst:
wenn das Ergebnis des Bestimmens, ob die Ähnlichkeit das vorbestimmte Niveau erreicht, ist, dass die Ähnlichkeit das vorbestimmte Niveau erreicht, Durchführen (S307) der dritten Sequenz von Wiederherstellungsoperationen des generativen Modells ausgehend von dem zweiten Bild, sodass eine letzte Wiederherstellungsoperation der dritten Sequenz eine letzte Wiederherstellungsoperation des generativen Modells ist, die das endgültige Halbleitermuster ausgibt; und
wenn das Ergebnis des Bestimmens, ob die Ähnlichkeit das vorbestimmte Niveau erreicht, ist, dass die Ähnlichkeit das vorbestimmte Niveau nicht erreicht, Erzeugen jeweiliger dritter Bilder durch Durchführen (S308) nachfolgender Wiederherstellungsoperationen unter den mehreren Wiederherstellungsoperationen ausgehend von dem zweiten Bild, basierend auf dem ersten eingestellten Wiederherstellungsprozess und vor der dritten Sequenz von Wiederherstellungsoperationen.

4. Verfahren nach Anspruch 3, wobei das Erzeugen des endgültigen Halbleitermusters Folgendes umfasst: wenn das Durchführen einer Ähnlichkeitsbestimmung (S309) zwischen einem der jeweiligen dritten Bilder und einem nachfolgenden der jeweiligen dritten Bilder das Erreichen eines vorbestimmten Mindestniveaus bestimmt, Abbrechen des Durchführens der nachfolgenden Wiederherstellungsoperationen und Beginnen des Durchführens der dritten Sequenz von Wiederherstellungsoperationen des generativen Modells ausgehend von dem nachfolgenden der jeweiligen dritten Bilder, sodass die letzte Wiederherstellungsoperation der dritten Sequenz die letzte Wiederherstellungsoperation des generativen Modells ist, die das endgültige Halbleitermuster ausgibt.

5. Verfahren nach einem der vorhergehenden Ansprüche, ferner umfassend das Durchführen der Ähnlichkeitsbestimmung zwischen dem ersten Bild und dem zweiten Bild durch:
Extraktion (S302, S304) eines ersten Merkmals und eines zweiten Merkmals aus dem ersten Bild bzw. dem zweiten Bild;
Umwandlung des ersten Merkmals und des zweiten Merkmals in einen ersten Merkmalsvektor bzw. einen zweiten Merkmalsvektor;
Messung der Ähnlichkeit zwischen dem ersten Bild und dem zweiten Bild durch Vergleichen des ersten Merkmalsvektors mit dem zweiten Merkmalsvektor;
Zuweisung eines Ähnlichkeitswertes zu einem Ergebnis der Messung und Bestimmung, ob dieser Ähnlichkeitswert einen vorbestimmten Schwellenwert erreicht; und
als Reaktion darauf, dass der Ähnlichkeitswert den vorbestimmten Schwellenwert erreicht, Bestimmung, dass das erste Bild und das zweite Bild ähnlich sind, und Durchführung der dritten Sequenz von Wiederherstellungsoperationen des generativen Modells ausgehend von dem zweiten Bild, sodass eine letzte Wiederherstellungsoperation der dritten Sequenz eine letzte Wiederherstellungsoperation des generativen Modells ist, die das endgültige Halbleitermuster ausgibt.

6. Verfahren nach Anspruch 5, wobei die Messung der Ähnlichkeit zwischen dem ersten Bild und dem zweiten Bild eine Messung einer Ähnlichkeit zwischen dem ersten Merkmalsvektor und dem zweiten Merkmalsvektor durch auf der euklidischen Distanz, der Kosinus-Ähnlichkeit und/oder der Manhattan-Distanz basierende Messungen umfasst.

7. Verfahren nach einem der vorhergehenden Ansprüche, wobei die Vielzahl von Wiederherstellungsoperationen des generativen Modells jeweils unterschiedlich zeitlich abgestimmte Wiederherstellungsoperationsschritte sind, von einem ersten Wiederherstellungsoperationsschritt über Zwischenschritte bis hin zu einem letzten Wiederherstellungsoperationsschritt, der einer letzten Wiederherstellungsoperation des generativen Modells entspricht, und
wobei eine Ablaufsteuerung von entsprechenden Wiederherstellungsoperationen des generativen Modells, wenn es basierend auf dem ersten eingestellten Wiederherstellungsprozess implementiert wird, nach einer ersten Zeitschrittlänge erfolgt, die sich von einer zweiten Zeitschrittlänge des zweiten eingestellten Wiederherstellungsprozesses unterscheidet, der eine Ablaufsteuerung anderer entsprechender Wiederherstellungsoperationen des generativen Modells definiert, wenn es basierend auf dem zweiten eingestellten Wiederherstellungsprozess implementiert wird.

8. Verfahren nach Anspruch 7, wobei die zweite Zeitschrittlänge länger ist als die erste Zeitschrittlänge.

9. Verfahren nach einem der vorhergehenden Ansprüche, ferner umfassend das Durchführen der Ähnlichkeitsbestimmung zwischen dem ersten Bild und dem zweiten Bild durch Extrahieren eines ersten Merkmals aus dem ersten Bild bzw. eines zweiten Merkmals aus dem zweiten Bild und Vergleichen des ersten Merkmals mit dem zweiten Merkmal,
wobei das erste Merkmal und das zweite Merkmal jeweils mindestens eines der folgenden Merkmale umfassen: Farbe, Textur, Form, Begrenzung, detailliertes Muster und Merkmalspunkt, und/oder wobei das erste Merkmal und das zweite Merkmal jeweils ein semantisches Merkmal umfassen.

10. Verfahren nach einem der vorhergehenden Ansprüche, ferner umfassend:
Einstellen einer ersten Variable in einem Speicher zum Speichern eines Wertes eines Zeitschritts nach dem eine Wiederherstellungsoperation des auf dem zweiten eingestellten Wiederherstellungsprozess basierenden generativen Modells ablaufen soll;
Verwalten einer zweiten Variable im Speicher zum Darstellen des dekrementierten ganzzahligen Wertes für die aktuellen Zeitschritte der jeweiligen Wiederherstellungsoperationen des generativen Modells, während die Vielzahl von Wiederherstellungsoperationen durchgeführt werden; und
Durchführen der dritten Sequenz des generativen Modells, wenn die zweite Variable die erste Variable erreicht.

11. Nichtflüchtiges, computerlesbares Speichermedium (10; 530; 560), auf dem Anweisungen gespeichert sind, welche, wenn sie von einem oder mehreren Prozessoren ausgeführt werden, den einen oder die mehreren Prozessoren veranlassen, das Verfahren nach einem der vorhergehenden Ansprüche durchzuführen.

12. Rechnervorrichtung (10; 50) mit einem oder mehreren Prozessoren (20; 510), die dazu konfiguriert sind, das Verfahren nach einem der Ansprüche 1 bis 10 durchzuführen.

## Revendications

1. Procédé mis en œuvre par processeur, le procédé comprenant :
la génération d'une première image par réalisation (S301), compte tenu d'un premier processus de restauration établi, d'une première séquence d'opérations de restauration d'un modèle génératif auquel avait initialement été fournie une image d'entrée, ledit modèle génératif étant un modèle génératif reposant sur une piste de circuit ayant une pluralité d'opérations de restauration ;
la génération d'une deuxième image par réalisation (S303), compte tenu du premier processus de restauration établi, d'une deuxième séquence d'opérations de restauration du modèle génératif à partir de la première image ; et
la génération, en fonction d'une similarité déterminée entre la première image et la deuxième image, d'une piste de semi-conducteur finale par réalisation (S307), compte tenu d'un deuxième processus de restauration établi différent du premier processus de restauration établi, de multiples opérations de restauration, y compris une troisième séquence d'opérations de restauration du modèle génératif à partir de la deuxième image.

2. Procédé selon la revendication 1, dans lequel le premier processus de restauration établi comprend la réalisation d'une opération de restauration correspondante du modèle génératif par réalisation d'un débruitage sur une image courante, puis par ajout d'un bruit aléatoire au résultat du débruitage, et dans lequel le deuxième processus de restauration établi comprend la réalisation d'une opération de restauration correspondante différente du modèle génératif par réalisation du débruitage sans ajout de bruit aléatoire au résultat du débruitage.

3. Procédé selon la revendication 1 ou 2, comprenant en outre la réalisation (S305) de la détermination de similarité entre la première image et la deuxième image compte tenu d'une première caractéristique extraite de la première image et d'une deuxième caractéristique extraite de la deuxième image, et une détermination permettant d'établir si la similarité atteint un niveau prédéterminé,
ladite génération de la piste de semi-conducteur finale comprenant :
lorsque le résultat de la détermination permettant d'établir si la similarité atteint le niveau prédéterminé est que la similarité atteint ledit niveau prédéterminé, la réalisation (S307) de la troisième séquence d'opérations de restauration du modèle génératif à partir de la deuxième image, de façon qu'une opération de restauration finale de la troisième séquence consiste en une opération de restauration finale du modèle génératif qui produit la piste de semi-conducteur finale ; et
lorsque le résultat de la détermination permettant d'établir si la similarité atteint le niveau prédéterminé est que la similarité n'atteint pas le niveau prédéterminé, la génération de troisièmes images respectives par réalisation (S308) d'opérations de restauration ultérieures, parmi les multiples opérations de restauration à partir de la deuxième image, compte tenu du premier processus de restauration établi et avant la troisième séquence d'opérations de restauration.

4. Procédé selon la revendication 3, dans lequel la génération de la piste de semi-conducteur finale comprend, lorsque le résultat d'une détermination de similarité (S309) entre l'une des troisièmes images respectives et une troisième image ultérieure respective est qu'un niveau minimum prédéterminé est atteint, l'arrêt de la réalisation des opérations de restauration ultérieures et le commencement de la réalisation de la troisième séquence d'opérations de restauration du modèle génératif à partir de ladite troisième image ultérieure respective, de façon que l'opération de restauration finale de la troisième séquence consiste en l'opération finale de restauration du modèle génératif qui produit la piste de semi-conducteur finale.

5. Procédé selon l'une quelconque des revendications précédentes, comprenant en outre la réalisation de la détermination de la similitude entre la première image et la deuxième image par :
extraction (S302, S304) d'une première caractéristique et d'une deuxième caractéristique respectivement de la première image et de la deuxième image,
conversion de la première caractéristique et de la deuxième caractéristique respectivement en un premier vecteur caractéristique et un deuxième vecteur caractéristique,
mesure de la similarité entre la première image et la deuxième image par comparaison du premier vecteur caractéristique au deuxième vecteur caractéristique,
attribution d'un score de similarité à un résultat de la mesure et détermination du fait que le score atteint un seuil prédéterminé ou non, et
en réaction à la détermination du fait que le score de similarité atteint le seuil prédéterminé, détermination du fait que la première image et la deuxième image sont similaires, et réalisation de la troisième séquence d'opérations de restauration du modèle génératif à partir de la deuxième image, de façon qu'une opération de restauration finale de la troisième séquence consiste en une opération de restauration finale du modèle génératif qui produit la piste de semi-conducteur finale.

6. Procédé selon la revendication 5, dans lequel la mesure de la similarité entre la première image et la deuxième image comprend la mesure d'une similarité entre le premier vecteur caractéristique et le deuxième vecteur caractéristique grâce à des mesures fondées sur la distance euclidienne, la similarité cosinus et/ou la distance de Manhattan.

7. Procédé selon l'une quelconque des revendications précédentes, dans lequel la pluralité d'opérations de restauration du modèle génératif sont respectivement des étapes d'opération de restauration à durées différentes, comptant une première étape d'opération de restauration, des étapes d'opération de restauration intermédiaires et une étape d'opération de restauration finale correspondant à une opération de restauration finale du modèle génératif, et
dans lequel un séquencement des opérations de restauration correspondantes du modèle génératif, lorsqu'il est mis en œuvre compte tenu du premier processus de restauration établi, s'effectue selon une première durée de pas de temps différente d'une deuxième durée de pas de temps du deuxième processus de restauration établi qui définit un séquencement d'autres opérations de restauration correspondantes du modèle génératif lorsqu'il est mis en œuvre compte tenu du deuxième processus de restauration établi.

8. Procédé selon la revendication 7, dans lequel la deuxième durée de pas de temps est plus longue que la première durée de pas de temps.

9. Procédé selon l'une quelconque des revendications précédentes, comprenant en outre la réalisation de la détermination de similarité entre la première image et la deuxième image par extraction, respectivement, d'une première caractéristique de la première image et d'une deuxième caractéristique de la deuxième image et par comparaison de la première caractéristique à la deuxième caractéristique,
ladite première caractéristique et ladite deuxième caractéristique comprenant chacune au moins une des caractéristiques suivantes : couleur, texture, forme, contour, motif détaillé et point caractéristique, et/ou ladite première caractéristique et ladite deuxième caractéristique comprenant chacune une caractéristique sémantique.

10. Procédé selon l'une quelconque des revendications précédentes, comprenant en outre :
l'établissement d'une première variable dans une mémoire pour stocker la valeur d'un pas de temps auquel une opération de restauration du modèle génératif fondé sur le deuxième processus de restauration doit s'effectuer ;
le maintien d'une deuxième variable en mémoire pour représenter des valeurs entières décrémentées relatives aux pas de temps actuels des opérations de restauration respectives du modèle génératif, tandis que la pluralité d'opérations de restauration sont réalisées ; et
la réalisation de la troisième séquence du modèle génératif lorsque la deuxième variable atteint la première variable.

11. Support de stockage non transitoire lisible par ordinateur (10; 530; 560) sur lequel sont stockées des instructions qui, lorsqu'elles sont exécutées par un ou plusieurs processeurs, amènent le ou les processeurs à réaliser le procédé selon l'une quelconque des revendications précédentes.

12. Dispositif informatique (10 ; 50) comprenant un ou plusieurs processeurs (20 ; 510) configurés pour réaliser le procédé selon l'une quelconque des revendications 1 à 10.
